Europäisches Patentamt

European Patent Office

Office européen des brevets

(19)

(11) Numéro de publication : **0 123 618**
**B1**

# (12) FASCICULE DE BREVET EUROPÉEN

(45) Date de publication du fascicule du brevet :
21.10.87

(21) Numéro de dépôt : 84400775.7

(22) Date de dépôt : 18.04.84

(51) Int. Cl.⁴ : **H 03 M   1/00**

(54) **Dispositif de lecture, par diascopie, de code optique et son procédé de fabrication.**

(30) Priorité : 20.04.83 FR 8306482

(43) Date de publication de la demande :
31.10.84 Bulletin 84/44

(45) Mention de la délivrance du brevet :
21.10.87 Bulletin 87/43

(84) Etats contractants désignés :
AT BE CH DE FR GB IT LI LU NL SE

(56) Documents cités :
CH-A-   381 127
DE-A- 2 915 027

(73) Titulaire : **M. C. B.**
**11, rue Pierre-Lhomme**
**F-92404 Courbevoie (FR)**

(72) Inventeur : **Taillebois, Jacques André Joseph**
**Résidence Brigitte 23, rue des Ebisoires**
**F-78370 Plaisir (FR)**

(74) Mandataire : **Lecca, Jean et al**
**CABINET PLASSERAUD 84, rue d'Amsterdam**
**F-75009 Paris (FR)**

## Description

La présente invention concerne les dispositifs de lecture, par diascopie, d'un code optique porté par un disque ou une réglette transparent.

On sait qu'un tel dispositif comprend — en combinaison avec un disque ou une réglette comportant une succession de zones opaques et de zones transparentes fines alternantes — une source de lumière, un réticule ou un index de lecture, et un photodétecteur qui détecte si c'est une zone opaque ou une zone transparente qui se présente devant le réticule ou l'index, l'ensemble source-réticule (ou index)-photodétecteur, d'une part, et le disque ou la réglette, d'autre part, étant mobiles l'un par rapport à l'autre, soit en rotation (cas du disque), soit en translation (cas de la réglette).

Des dispositifs de lecture, par diascopie, d'un code optique sont décrits par exemple dans les brevets des Etats-Unis n° 3.187.187 (Wingate), 4.182.953 (Hurley et Krystek) et 4.338.517 (Perrine).

Généralement le disque ou la réglette est porté par une pièce mécanique dont on veut repérer la position angulaire (cas du disque) ou linéaire (cas de la réglette), tandis que, dans le lecteur proprement dit, la source lumineuse, l'index (ou le réticule) et le photodétecteur sont parfaitement alignés pour définir un trajet optique bien déterminé : la lumière émise par la source frappe le support en forme de disque ou de réglette à zones alternativement opaques et transparentes, en traversant celui-ci seulement si une zone transparente se trouve en regard de l'index ou réticule, qui est constitué en général par une fente étroite ayant avantageusement la largeur des zones transparentes, et en venant alors frapper le photodétecteur qui émet un signal électrique en réponse au passage de chaque zone transparente en regard de l'index ou réticule ; ce signal est amplifié et mis en forme dans une unité électronique associée au photodétecteur, avant d'être compté ou enregistré par exemple.

Lorsqu'on prévoit plusieurs pistes de lecture sur le disque ou la réglette, le dispositif de lecture comporte très généralement autant d'ensembles source-index (ou réticule)-photodétecteur (avec unité électronique associée) qu'il y a de pistes, par exemple dix tels ensembles pour un codeur à dix bits.

On connaît d'après la partie inférieure droite de la figure 2 et la description correspondante du document DE-A-29 15 027, publiée pour la première fois le 23 octobre 1980, un dispositif de lecture, par diascopie, de code optique comportant un châssis métallique replié en U, une source de lumière portée par l'un des deux flancs du châssis en U, un photodétecteur porté par l'autre flanc du châssis en U, des pattes de fixation, par lesquelles ledit dispositif de lecture est fixé sur un organe mécanique fixe avec un élément mobile porteur d'une piste codée optiquement, et des connexions de raccordement électrique.

La présente invention a pour but de réaliser un dispositif de lecture ou lecteur optique de ce type qui soit très précis et bon marché à la fois.

Elle a encore pour but de réaliser un tel lecteur optique par un procédé automatique qui, tout en permettant de produire de grandes séries, soit à la fois précis et simple et apte à produire des lecteurs précis peu coûteux.

Un dispositif de lecture par diascopie, de code optique, selon l'invention comprend un châssis métallique replié en U avec, d'une part, un premier support pour une source de lumière porté par l'un des deux flancs du châssis en U et, d'autre part, un second support pour au moins un photodétecteur, ainsi que des connexions de raccordement de photodétecteur et des pattes de fixation pour la fixation du dispositif de lecture sur un organe mécanique fixe et qui coopère avec un élément mobile porteur d'au moins une piste codée optiquement, ce dispositif de lecture étant caractérisé en ce que

·la source de lumière fournit un faisceau de rayons parallèles ;

le photodétecteur fait partie d'une puce de circuit intégré ; et

le châssis métallique replié en U comporte une aile latérale échancrée assurant la superposition optique correcte du dispositif de lecture avec ladite au moins une piste codée optiquement.

L'invention concerne également l'ensemble dispositif de lecture optique-organe mécanique ainsi obtenu.

Le procédé de fabrication d'un tel dispositif de lecture optique comprend les phases suivantes :

on découpe dans une bande métallique une série de châssis constitués par des grilles successives, chacune comportant un premier support pour une source de lumière et un second support pour une puce de circuit intégré et une aile latérale échancrée ;

on dépose sur le second support de ladite grille une puce de circuit intégré ;

on replie en U ledit châssis, les deux supports étant portés chacun par un des flancs du chassis replié ;

on introduit une source de lumière. parallèle dans le premier support de ladite grille.

Avantageusement, on réalise le découpage des grilles dans la bande métallique en une série d'opérations successives en plusieurs postes de travail disposés côte-à-côte, la bande passant devant ces postes en étant avancée pas-à-pas.

Pour réaliser la mise en place correcte des différents éléments sur la grille, on peut faire comporter à celle-ci des trous de centrage et/ou l'échancrure de ladite aile a la forme d'un Vé dont l'ouverture forme de préférence un angle obtus.

Le bloc est avantageusement réalisé en une résine, telle qu'une résine époxy, ou en céramique.

Pour former un ensemble complet dispositif de lecture optique-organe mécanique avec support de piste codée, on réalise ensuite l'assemblage en utilisant l'aile latérale échancrée du dispositif de lecture ainsi fabriqué avec ledit organe, au moyen de pattes de fixation prévues sur ladite grille.

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 illustre la première phase opératoire du procédé de fabrication du lecteur optique selon l'invention, à savoir le découpage dans une bande métallique d'une succession de châssis ou grilles.

Les figures 2 et 3 illustrent respectivement la deuxième phase (mise en place du bloc de matière) et la troisième phase (mise en place de la puce de circuit intégré) de ce procédé.

La figure 4 illustre, en perspective cavalière, les phases suivantes du procédé (repliement du châssis et mise en place de la source de lumière) et le montage du lecteur optique sur un organe mécanique avec mise en place d'un disque codé optiquement.

La figure 5 enfin, illustre, en perspective cavalière, un lecteur optique selon l'invention en place sur un organe mécanique tournant avec un disque codé optiquement.

On va maintenant exposer comment l'on réalise un dispositif de lecture par diascopie, précis et peu coûteux, par une mise en œuvre du procédé selon l'invention.

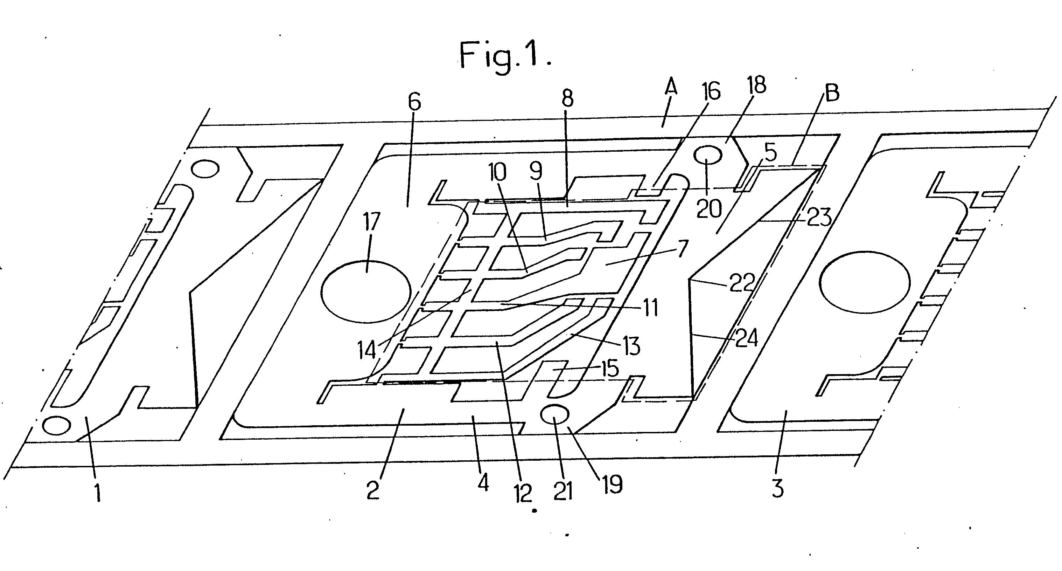

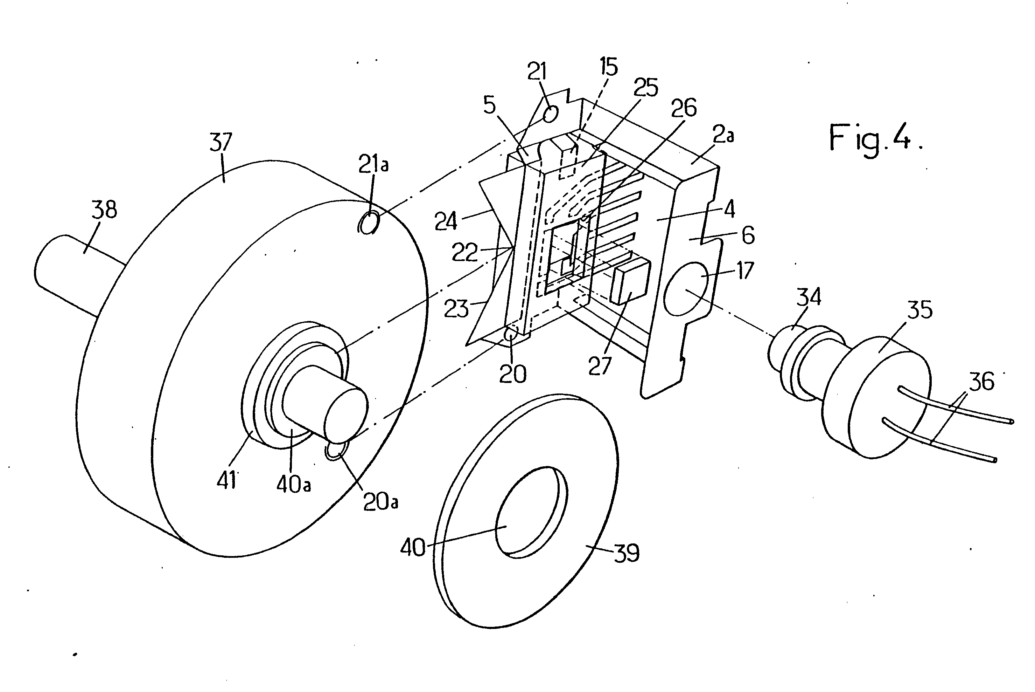

On part d'un ruban ou bande métallique A, notamment d'un ruban en acier. On découpe celui-ci à plat, comme illustré sur la figure 1, en réalisant une succession d'opérations en une série de postes de travail devant lesquels passe la bande 1 qui est avancée pas-à-pas par des moyens non représentés. On obtient ainsi une série de châssis plats 1, 2, 3. Chaque châssis après découpage constitue une grille qui sera ensuite (comme expliqué ultérieurement) repliée comme illustré sur la figure 4 (châssis replié 2a).

Le châssis (illustré à plat sur la figure 1 et à l'état replié sur la figure 4) comprend essentiellement trois parties 4, 5 et 6, à savoir une partie centrale 4 et deux parties latérales 5 et 6.

La partie centrale 4 comprend un plan support 7 pour la puce de circuit intégré et des connexions 8, 9, 10, 11, 12 et 13 pour le circuit intégré de ladite puce, une lame 14 retenant initialement les connexions 8 à 13 en position ; cette partie centrale 4 comprend également deux pattes de renforcement 15 et 16 pour l'accrochage du bloc en matière plastique dont il sera fait mention ci-après.

La partie latérale 6 constitue le support pour la source lumineuse et il présente à cet effet un orifice 17 destiné à recevoir cette source de lumière.

Quant à la partie latérale 5, elle comporte, d'une part, des pattes de fixation 18 et 19, percées respectivement de trous de centrage 20 et 21 et, d'autre part, un Vé de centrage 22 avec ses deux flancs d'appui rectilignes 23 et 24 formant un angle obtus.

On procède ensuite à une légère surélévation de la partie B (entourée par un contour en traits interrompus sur la figure 1) par rapport au plan de la figure 1.

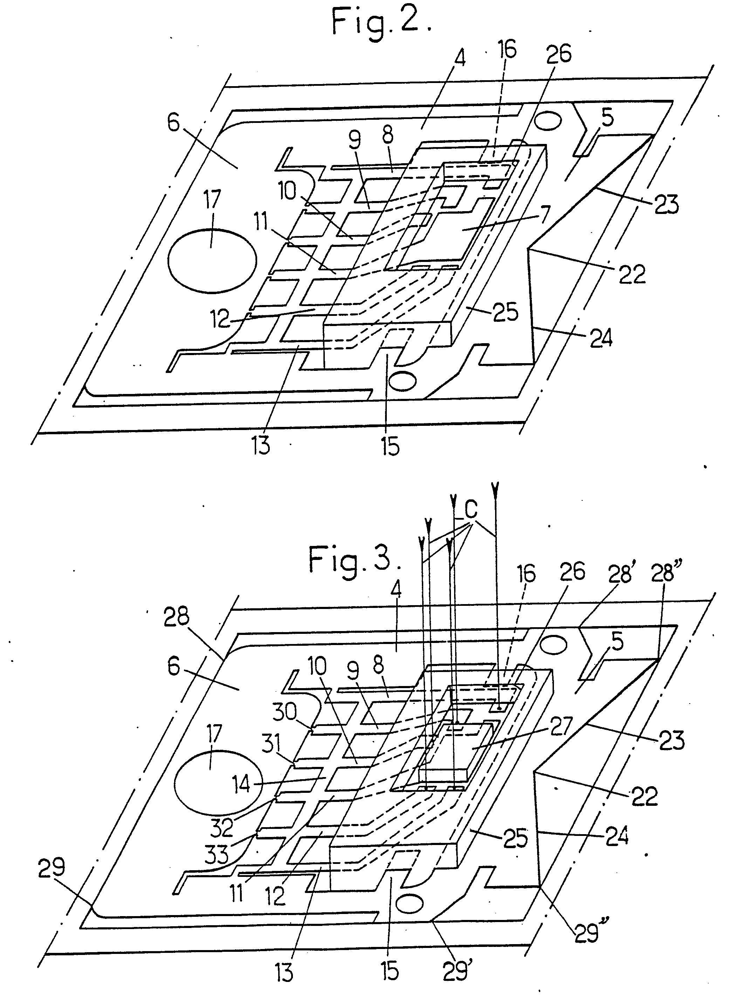

Après l'opération de découpage de la grille 2 (comme illustré sur la figure 1) et la surélévation de la partie B de celle-ci, opérations qui constituent la première phase du procédé selon l'invention, on procède à la deuxième phase illustrée sur la figure 2. Cette seconde phase consiste à apporter un bloc 25 en une matière plastique (par exemple en une résine époxy) ou en céramique, disposé de part et d'autre de la partie B et dans lequel seront englobées, après pliage (quatrième phase de l'opération), les pattes de renforcement 15 et 16. Ce bloc 25 comporte un évidement rectangulaire 26 destiné à recevoir une puce de circuit intégré de dimension inférieure à la dimension de l'évidement 26. La mise en position correcte du bloc 25 est réalisée avec un outil de moulage positionné grâce aux trous de centrage 20 et 21.

La troisième phase opératoire (figure 3) consiste à disposer dans l'évidement 26 la puce de circuit intégré 27, puis on effectue des points de soudure de cette puce sur les connexions 8 à 13, aux endroits indiqués par des flèches C. La mise en place de la puce 27 dans l'évidement 26, en position correcte sur le plan de support 7, est faite par exemple à ± 5 $\mu$m près par une machine qui prend référence sur le Vé de centrage 22 et ses flancs 23 et 24.

Après contrôle du fonctionnement du circuit intégré de la puce, on dispose une fenêtre, par exemple en verre soudé ou collé (non représentée) sur le bloc de matière plastique 25, de manière à fermer l'évidement 26 en protégeant la puce de circuit intégré notamment contre les poussières et l'humidité. On peut remplacer la fenêtre par un dépôt de résine ou de vernis transparent.

On coupe alors les points d'attache 28, 28', 28", 29, 29', 29", d'une part, et 30, 31, 32 et 33, d'autre part, puis on replie à angle droit les zones latérales de la grille par rapport à la zone centrale de celle-ci. C'est la quatrième phase du procédé selon l'invention, et on obtient ainsi le châssis replié 2a de la figure 4 (sur cette figure on a représenté, pour des raisons de clarté, la puce de circuit intégré 27 en dehors de l'évidement 26 du bloc 25).

Une fois le châssis ainsi replié, avec les pattes de renforcement 16 et 17 en position dans le bloc 25, on loge la tête 34 de la source de lumière 35 dans l'orifice 17, une collerette (non visible sur la figure 4) de la source de lumière 35 s'appuyant sur la partie 6 qui sert de radiateur pour le refroidissement de la source de lumière. La tête 34 de la source de lumière comprend un système optique qui émet un faisceau de lumière parallèle dirigé sur la puce 27 (en position dans l'évidement 26), en regard de cette source de lumière. Cette source est alimentée en courant par des conducteurs 36.

La figure 4 illustre également le montage du dispositif de lecture qui vient d'être ainsi réalisé sur un corps de codeur constitué par une pièce fixe 37 destinée à recevoir ce dispositif de lecture et d'un axe tournant 38, sur lequel est monté un disque codé 39 percé d'un trou 40 dans lequel pénètre une collerette cylindrique 40a s'appliquant contre une embase circulaire solidaire de la pièce fixe 37 et assurant le centrage du disque codé 39. Le disque codé 39 tourne à une certaine distance de la pièce 37 pour permettre la mise en place, entre cette pièce 37 et le disque 39, du bloc 25 avec la puce 27.

Le disque 39 peut par exemple être réalisé, à la manière connue, en verre et comporter un dépôt constitué par une couche mince microgravée.

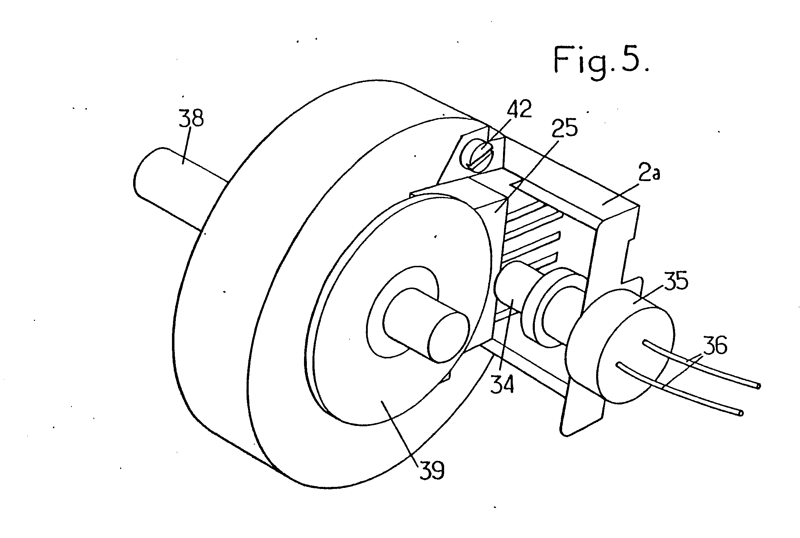

La mise en place du dispositif de lecture, à source de lumière 35 et puce de circuit intégré 27, sur la pièce fixe 37, a lieu au moyen de boulons 42 (figure 5) traversant les trous 20 et 21 du dispositif de lecture et les trous correspondants 20a et 21a de la pièce 37. On obtient ainsi l'ensemble dispositif de lecture-axe tournant 38 avec disque codé 39 illustré sur la figure 5.

Le dispositif de lecture selon l'invention permet de lire par diascopie les inscriptions du disque codé 39 constitué par une succession de zones transparentes et de zones opaques, la lumière parallèle issue de la source 35 traversant les zones transparentes du disque 35 pour frapper la puce de circuit intégré 27.

La puce de circuit intégré peut comprendre une série de photodétecteurs rectangulaires de très petites dimensions, par exemple de $100 \times 50$ µm, ce qui permet d'avoir plusieurs pistes sur le disque 39, le dispositif de lecture ne comportant qu'une source de lumière et une seule puce, à la place de plusieurs dispositifs unitaires selon la technique antérieure, comme il a été précisé dans le préambule.

On obtient ainsi un dispositif de lecture de code optique très précis et très bon marché grâce à un procédé de fabrication qui peut être automatisé pour une production en grande série.

Le dispositif de lecture est robuste, il permet une adaptation facile à tout diamètre de disque codé et une mise en place précise et rapide par rapport au disque codé, la puce de circuit intégré (non visible sur la figure 5) se trouvant derrière le disque codé dans le bloc de matière plastique 25.

Les trous de centrage 20 et 21 et le Vé de centrage 22, avec ses flancs 23 et 24, permettent une mise en place très précise des différents éléments du dispositif de lecture, d'une part, et de mise en place de ce dispositif par rapport au disque codé, d'autre part, les flancs 23 et 24 du Vé venant prendre appui tangentiellement contre l'embase circulaire 41.

Comme il va de soi et comme il résulte d'ailleurs déjà de ce qui précède, l'invention ne se limite nullement a ceux de ses modes d'application et de réalisation qui ont été plus spécialement envisagés ; elle en embrasse, au contraire, toutes les variantes.

Ainsi par exemple au lieu de fixer sur le support 7 du châssis un bloc 25 de matière plastique ou autre, dans lequel est ménagé un logement 26 destiné à recevoir la puce de circuit intégré 27 et à être fermé par une fenêtre ou un dépôt transparent, on peut fixer sur le support 7 du châssis un boîtier étanche dans lequel est logé la puce 27, ce boîtier comportant, sur sa face opposée à celle qui est fixée sur le support 7, une fenêtre transparente. Ce boîtier peut renfermer, en plus de la puce, d'autres composants électroniques associés à la puce et à ses photodétecteurs. Dans ce cas il peut être avantageux d'effectuer sur la fenêtre transparente un dépôt métallique opaque partiel constituant un masque qui ne laisse visibles que les photodétecteurs de la puce de circuit intégré. Le boîtier peut être par exemple du type classique (flat pack) ou du type spécial avec des pattes latérales de fixation pour soudure électrique ou collage sur le châssis métallique, ces pattes latérales de fixation étant « électriquement en l'air ». Le boîtier peut soit comprendre des connexions de sortie, soit être monté autour des connexions 8 à 13 du châssis qui constituent alors ses connexions de sortie.

## Revendications

1. Dispositif de lecture, par diascopie, de code optique, qui comprend un châssis métallique (2a) replié en U avec, d'une part, un premier support (6) pour une source de lumière porté par l'un des deux flancs du châssis en U et, d'autre part, un second support (7) pour au moins un photodétecteur, ainsi que des connexions (8-13) de raccordement de photodétecteur et des pattes de fixation (18, 19) pour la fixation du dispositif de lecture sur un organe mécanique fixe (37) et qui coopère avec un élément mobile (38) porteur d'au moins une piste codée optiquement (39), ce dispositif de lecture étant caractérisé en ce que
   la source de lumière (38) fournit un faisceau de rayons parallèles ;
   le photodétecteur fait partie d'une puce de circuit intégré (27) ; et
   le châssis métallique replié en U comporte une aile latérale échancrée assurant la superposition optique correcte du dispositif de lecture avec ladite au moins une piste codée optiquement.

2. Dispositif selon la revendication 1, caractérisé en ce que la puce de circuit intégré (27) comporte plusieurs photodétecteurs avec leurs circuits associés d'amplification et de mise en forme.

3. Dispositif selon la revendication 1 ou 2, caractérisé en ce que ladite aile latérale échancrée (22) comprend un Vé de centrage avec deux flancs rectilignes (23, 24) formant de préférence un angle obtus.

4. Dispositif selon l'une quelconque des revendications 1 à 3, caractérisé en ce que ledit châssis métallique (2a) comporte au moins deux trous de centrage (20, 21).

5. Dispositif de lecture selon l'une quelconque des revendications précédentes, caractérisé en ce que le châssis métallique (2a) porte un bloc (25) avec un évidement (26) dans lequel est logée la puce de circuit intégré (27).

6. Dispositif selon la revendication 5, caractérisé en ce que ledit bloc (25) est en une matière plastique ou en céramique.

7. Dispositif selon la revendication 5 ou 6, caractérisé en ce que ledit évidement (26) dans lequel est logée la puce (27) est fermé par une fenêtre transparente.

8. Dispositif selon la revendication 5 ou 6, caractérisé en ce que ledit évidement (26) dans lequel est logée la puce (27) est fermé par un dépôt transparent.

9. Dispositif selon l'une quelconque des revendications 1 à 4, caractérisé en ce que la puce de circuit intégré (27) est montée dans un boîtier qui est fixé sur ledit second support (7) et qui comporte des connexions de sortie.

10. Dispositif selon la revendication 9, caractérisé en ce que le boîtier comporte une fenêtre transparente sur la face opposée à celle fixée sur ledit second support (7).

11. Dispositif selon la revendication 10, caractérisé en ce que ladite fenêtre comporte un dépôt métallique constituant un masque optique qui ne laisse transparente que la partie se trouvant au-dessus du ou des photodétecteurs de ladite puce (27).

12. Ensemble constitué par un dispositif de lecture selon l'une quelconque des revendications précédentes et par un organe mécanique fixe (37) avec un élément mobile (38) porteur d'au moins une piste codée optiquement (39).

13. Ensemble selon la revendication 12, caractérisé en ce que ledit élément porteur est constitué par une plaque de part et d'autre duquel viennent se placer, d'une part, ladite puce de circuit intégré et, d'autre part, ladite source de lumière.

14. Procédé de fabrication d'un dispositif de lecture optique selon l'une quelconque des revendications 1 à 11, caractérisé en ce qu'il comprend les phases suivantes :

on découpe dans une bande métallique une série de châssis constitués par des grilles successives, chacune comportant un premier support pour une source de lumière et un second support pour une puce de circuit intégré et une aile latérale échancrée ;

on dépose sur le second support de ladite grille une puce de circuit intégré ;

on replie en U ledit châssis, les deux supports étant portés chacun par un des flancs du châssis replié ;

on introduit une source de lumière parallèle dans le premier support de ladite grille.

15. Procédé selon la revendication 14 caractérisé en ce qu'on réalise le découpage des grilles dans la bande métallique en une série d'opérations successives en plusieurs postes de travail disposés côte à côte, la bande passant devant ces postes en étant avancée pas à pas.

16. Procédé selon la revendication 14 ou 15, caractérisé en ce qu'on fixe sur le second support du châssis un bloc avec un évidement, puis la puce dans l'évidement de ce bloc et ensuite on ferme l'évidement du bloc par un dépôt ou une fenêtre transparent.

17. Procédé selon la revendication 14 ou 15, caractérisé en ce qu'on fixe sur le second support du châssis un boîtier dans lequel est montée la puce, ledit boîtier comportant une fenêtre transparente sur la face opposée à celle fixée sur le second support.

18. Procédé pour réaliser un ensemble selon la revendication 12 ou 13, caractérisé en ce qu'on met en œuvre le procédé selon l'une quelconque des revendications 14 à 17 pour réaliser le dispositif de lecture et qu'on effectue ensuite l'assemblage, en utilisant l'aile latérale échancrée — notamment le Vé de centrage —, du dispositif de lecture ainsi fabriqué et d'un organe mécanique fixe avec un élément mobile porteur de piste codée optiquement, au moyen de pattes de fixation prévues sur ladite grille.

**Claims**

1. A device for reading optical code by diascopy, the device comprising a U-shaped metal chassis (2a) having, on the one hand, a first support (6) for a light source carried by one of the two sides of the U-chassis and, on the other hand, a second support (7) for at least one photodetector, and connections (8-13) for connecting the photodetector and fixing lugs (18, 19) for fixing the reading device on a stationary mechanical element (37) which co-operates with a movable element (38) carrying at least one optically coded track (39), said reading device being characterised in that :

the light source (38) delivers a beam of parallel rays ; the photodetector forms part of an integrated circuit chip (27) ; and

the U-shaped metal chassis has a notched side arm for correct optical superimposition of the reading device and the said at least one optically coded track.

2. A device according to claim 1, characterised in that the integrated circuit chip (27) comprises a plurality of photodetectors with their associated amplifier and shaping circuits.

3. A device according to claim 1 or 2, characterised in that the said notched side arm (22) has a centring-V with two rectilinear sides (23, 24) preferably forming an obtuse angle.

4. A device according to any one of claims 1 to 3, characterised in that the said metal chassis (2a) comprises at least two centring holes (20, 21).

5. A reading device according to any one of the preceding claims, characterised in that the metal chassis (2a) bears a block (25) with an opening (26) in which the integrated circuit chip (27) is accommodated.

6. A device according to claim 5, characterised in that the said block (25) is of plastics or ceramics.

7. A device according to claim 5 or 6, characterised in that the said opening (26) in which the chip (27) is accommodated is closed by a transparent window.

8. A device according to claim 5 or 6, characterised in that the said opening (26) in which the chip (27) is accommodated is closed by a transparent deposit.

9. A device according to any one of claims 1 to 4, characterised in that the integrated circuit chip (27) is mounted in a casing fixed on said second support (7) and comprising output connections.

10. A device according to claim 9, characterised in that the casing comprises a transparent window on the surface remote from that fixed on the said second support (7).

11. A device according to claim 10, characterised in that the said window comprises a metal deposit forming an optical mask which leaves transparent only that part which is situated above the or each photodetector of said chip (27).

12. An assembly comprising a reading device according to any one of the preceding claims and a stationary mechanical element (37) together with a movable element (38) carrying at least one optically coded track (39).

13. An assembly according to claim 12, characterised in that the said carrier element is a plate on either side of which the said integrated circuit chip and the said light source are respectively disposed.

14. A method of producing an optical reading device according to any one of claims 1 to 11, characterised in that it comprises the following stages :

a series of chassis formed by successive grids each comprising a first support for a light source and a second support for an integrated circuit chip and a notched side arm is cut from a metal strip ;

an integrated circuit chip is deposited on said second support of said grid ;

the said chassis is bent into a U shape, the two supports each being carried by one of the sides of the bent chassis ; a parallel light source is introduced into the first support of said grid.

15. A method according to claim 14, characterised in that the grids are cut from the metal strip in a series of successive operations in a plurality of working stations disposed side by side, the strip passing before said stations with a stepwise advance.

16. A method according to claim 14 or 15, characterised in that a block with an opening is fixed on said second support of the chassis and then the chip is fixed in the opening in said block and then the block opening is closed by a deposit or a transparent window.

17. A method according to claim 14 or 15, characterised in that a casing in which the chip is mounted is fixed on the second support of the chassis, said casing comprising a transparent window on the surface remote from that fixed on the second support.

18. A method of making an assembly according to claim 12 or 13, characterised in that the method according to any one of claims 14 to 17 is used to make the reading device and assembly is then carried out using the notched side arm, particularly the centring-V, of the reading device thus made and a stationary mechanical element with a movable element carrying the optically coded track, by means of fixing lugs provided on said grid.

## Patentansprüche

1. Diaskopisches Lesegerät für optischen Kode, mit einem U-förmig gebogenen Metallrahmen (2a), der einerseits einen ersten Träger (6) für eine Lichtquelle, welche von einem der beiden Schenkel des U-förmigen Rahmens getragen wird, und anderseits einen zweiten Träger (7) für zumindest einen Photodetektor bildet, sowie mit Verbindungen (8-13) zum Anschluß des Photodetektors und mit Befestigungslappen (18, 19) zum Befestigen des Lesegerätes an einem feststehenden mechanischen Organ (37), wobei das Gerät mit einem beweglichen Element (38) zusammenwirkt, welches zumindest eine optisch kodierte Spur (39) trägt, dadurch gekennzeichnet, daß

die Lichtquelle (38) ein Bündel paralleler Strahlen liefert,

der Photodetektor Teil eines Chips (27) mit integrierter Schaltung ist, und

der U-förmig gebogene Metallrahmen einen seitlichen Flansch mit einem Ausschnitt aufweist, welcher die korrekte optische Ausrichtung des Lesegerätes auf die zumindest eine optisch kodierte Spur sichert.

2. Gerät nach Anspruch 1, dadurch gekennzeichnet, daß der Chip (27) mehrere Photodetektoren mit deren zugeordneten Verstärkerkreisen und Impulsformern aufweist.

3. Gerät nach Anspruch 1 oder 2, dadurch gekennzeichnet, daß der Ausschnitt des seitlichen Flansches (22) zur Zentrierung ein V mit geraden Schenkeln (23, 24) bildet, die vorzugsweise einen stumpfen Winkel einschließen.

4. Gerät nach einem der Ansprüche 1 bis 3, dadurch gekennzeichnet, daß der Metallrahmen (2a) zumindest zwei Zentrieröffnungen (20, 21) hat.

5. Gerät nach einem der vorhergehenden Ansprüche, dadurch gekennzeichnet, daß der Metallrahmen (2a) einen Block (25) mit einer Ausnehmung (26) trägt, in welcher der Chip (27) angeordnet ist.

6. Gerät nach Anspruch 5, dadurch gekennzeichnet, daß der Block (25) aus Kunststoff oder Keramik besteht.

7. Gerät nach Anspruch 5 oder 6, dadurch gekennzeichnet, daß die Ausnehmung (26), in welcher der Chip (27) angeordnet ist, durch ein transparentes Fenster verschlossen ist.

8. Gerät nach Anspruch 5 oder 6, dadurch gekennzeichnet, daß die Ausnehmung (26), in welcher der Chip (27) angeordnet ist, durch eine transparente Ablagerung verschlossen ist.

9. Gerät nach einem der Ansprüche 1 bis 4, dadurch gekennzeichnet, daß der Chip (27) in einem Gehäuse angeordnet ist, das an dem zweiten Träger (7) befestigt ist und die Ausgangsanschlüsse trägt.

10. Gerät nach Anspruch 9, dadurch gekennzeichnet, daß das Gehäuse ein transparentes Fenster auf jener Seite aufweist, die der am zweiten Träger (7) befestigten Seite gegenüberliegt.

11. Gerät nach Anspruch 10, dadurch gekennzeichnet, daß das Fenster eine Metallablagerung trägt, die eine optische Maske bildet, welche nur jenen Teil transparent beläßt, der sich oberhalb des oder der Photodetektoren des Chips (27) befindet.

12. Anordnung, bestehend aus einem Lesegerät nach einem der vorhergehenden Ansprüche und einem feststehenden mechanischen Organ (37) mit einem beweglichen Tragelement (38) für zumindest eine optisch kodierte Spur (39).

13. Anordnung nach Anspruch 12, dadurch gekennzeichnet, daß das Tragelement durch eine Platte gebildet ist, auf deren einer Seite der Chip und auf deren anderer Seite die Lichtquelle anzuordnen sind.

14. Verfahren zum Herstellen eines optischen Lesegerätes nach einem der Ansprüche 1 bis 11, dadurch gekennzeichnet, daß es folgende Schritte aufweist:

Abtrennen von durch aufeinanderfolgende Gitterstrukturen gebildeten Rahmen der Reihe nach von einem Metallband, wobei jeder Rahmen einen ersten Träger für eine Lichtquelle, einen zweiten Träger für einen Chip mit integrierter Schaltung und einen seitlichen Flansch mit einem Ausschnitt aufweist;

Montage eines Chip mit integrierter Schaltung auf dem zweiten Träger jeder Gitterstruktur;

Biegen des Rahmens zu einem U, wobei die beiden Träger die Schenkel des gebogenen Rahmens bilden;

Einführen einer ein Bündel paralleler Strahlen liefernden Lichtquelle in den ersten Träger der Gitterstruktur.

15. Verfahren nach Anspruch 14, dadurch gekennzeichnet, daß das Abtrennen der Gitterstruktur vom Metallband durch eine Reihe von aufeinanderfolgenden Arbeitsvorgängen in mehreren nebeneinanderliegenden Arbeitsstationen erfolgt, wobei das Band schrittweise an den Arbeitsstationen vorbeigeführt wird.

16. Verfahren nach Anspruch 14 oder 15, dadurch gekennzeichnet, daß am zweiten Träger des Rahmens ein Block mit einer Ausnehmung befestigt wird, sodann der Chip in der Ausnehmung des Blockes angeordnet wird und hernach die Ausnehmung des Blockes durch eine transparente Ablagerung oder ein transparentes Fenster verschlossen wird.

17. Verfahren nach Anspruch 14 oder 15, dadurch gekennzeichnet, daß am zweiten Träger des Rahmens ein Gehäuse befestigt wird, in welchem der Chip montiert ist, wobei das Gehäuse auf der der Befestigungsseite an zweiten Träger gegenüberliegenden Seite ein transparentes Fenster aufweist.

18. Verfahren zum Herstellen einer Anordnung nach Anspruch 12 oder 13, dadurch gekennzeichnet, daß das Verfahren nach einem der Ansprüche 14-17 durchgeführt wird, um das Lesegerät herzustellen, und daß sodann unter Verwendung des seitlichen Flansches mit dem Ausschnitt — insbesondere einem zentrierenden V-Ausschnitt — der Zusammenbau des hergestellten Lesegerätes und eines feststehendes mechanisches Organes mit einem beweglichen Tragelement für die optisch kodierte Spur mittels Befestigungslappen vorgenommen wird, die an der Gitterstruktur vorgesehen sind.

7

# Fig.1.

0 123 618

# Fig.2.

# Fig.3.

Fig.4.

0 123 618

Fig.5.

38
42
25
2a
35
36
34
39

0 123 618